# EUROPEAN PATENT APPLICATION

(11) **EP 4 586 763 A1**
(43) Date of publication of application: **16.07.2025**
(21) Application number: 24195832.1
(22) Date of filing: 22.08.2024
(51) Int. Cl.: H10D 30/01, H10D 64/01, H10D 30/66

(54) **SEMICONDUCTOR DEVICE AND MANUFACTURING METHOD THEREOF**

(30) Priority: 10.01.2024 KR 20240004471
(71) Applicant: Samsung Electronics Co., Ltd., Gyeonggi-do, 16677 (KR)
(72) Inventor: NOH, Jeongin, Suwon-si (KR); KIM, Taehun, Suwon-si (KR); CHO, Doohyung, Suwon-si (KR); KIM, Jongseob, Suwon-si (KR); PARK, Young Hwan, Suwon-si (KR); HONG, Seongjo, Suwon-si (KR)
(74) Representative: Marks & Clerk LLP

(57) **Abstract**

A semiconductor device may include: a first conductivity type substrate; a first conductivity type semiconductor layer on a first surface of the first conductivity type substrate; a gate electrode on the first conductivity type semiconductor layer; a second conductivity type doping well region on the first conductivity type semiconductor layer; a gate insulation layer between the first conductivity type semiconductor layer and the gate electrode; a first interlayer insulating layer including a first portion on an upper surface of the gate electrode and a side surface of the gate electrode, and a second portion protruding from a first side surface of the first portion in a horizontal direction; a source electrode on the second conductivity type doping well region; a protection pattern on the second portion of the first interlayer insulating layer, and between the first portion of the first interlayer insulating layer and the source electrode; and a drain electrode on a second surface of the first conductivity type substrate.

## Description

### 1. Technical Field

The present invention generally relates to a semiconductor device. Embodiments of the present disclosure relate to a semiconductor device and a manufacturing method thereof. 2. Background

In modern society, semiconductor devices are closely related to daily life. In particular, the importance of power semiconductor devices used in various fields such as transportation fields (e.g., electric vehicles, railroads, and electric trams), renewable energy systems (e.g., solar power generation and wind power generation), and mobile devices is gradually increasing. Power semiconductor devices are semiconductor devices used to handle high voltage or high current, and perform functions such as power conversion and control in large power systems or high-output electronic devices. Power semiconductor devices have the ability and durability to handle high power, so they can handle large amounts of current and withstand high voltage. For example, power semiconductor devices can handle voltages from hundreds of volts to thousands of volts and currents from tens of amperes to thousands of amperes. Power semiconductor devices can improve efficiency of electrical energy by minimizing power loss. Additionally, power semiconductor devices can be stably driven even in environments including high temperatures.

These power semiconductor devices can be classified according to materials, and examples include SiC power semiconductor devices and GaN power semiconductor devices. By manufacturing power semiconductor devices using SiC or GaN instead of existing silicon wafers, disadvantage of silicon, which has unstable characteristics at high temperatures, can be compensated. SiC power semiconductor devices are resistant to high temperatures and have low power loss, and can be suitable for electric vehicles, renewable energy systems, etc. GaN power semiconductor devices require high costs, but are efficient in terms of speed and can be suitable for high-speed charging of mobile devices.

### SUMMARY

The present invention provides a semiconductor device as defined by claim 1. Preferred embodiments are defined by the dependent claims.

According to an aspect of an embodiment of the present disclosure, a semiconductor device includes: a first conductivity type substrate; a first conductivity type semiconductor layer on a first surface of the first conductivity type substrate; a gate electrode on the first conductivity type semiconductor layer; a second conductivity type doping well region on the first conductivity type semiconductor layer; a gate insulation layer between the first conductivity type semiconductor layer and the gate electrode; a first interlayer insulating layer including a first portion on an upper surface of the gate electrode and a side surface of the gate electrode, and a second portion protruding from a first side surface of the first portion in a horizontal direction; a source electrode on the second conductivity type doping well region; a protection pattern on the second portion of the first interlayer insulating layer, and between the first portion of the first interlayer insulating layer and the source electrode; and a drain electrode on a second surface of the first conductivity type substrate, the first surface and the second surface facing in opposite directions from each other.

According to an aspect of an embodiment of the present disclosure, a manufacturing method of a semiconductor device includes: forming a first conductivity type semiconductor layer on a first surface of a first conductivity type substrate; forming a second conductivity type doping well region, a first conductivity type doping layer, and a second conductivity type doping layer on the first conductivity type semiconductor layer; forming a gate insulation layer on the first conductivity type semiconductor layer; forming a gate electrode on the gate insulation layer; forming a first interlayer insulating material layer on the gate electrode, the first conductivity type doping layer, and the second conductivity type doping layer; forming a preliminary protection pattern on the first interlayer insulating material layer; forming a protection pattern on the first interlayer insulating material layer by etching the preliminary protection pattern; forming a first interlayer insulating layer by etching the first interlayer insulating material layer, the first interlayer insulating layer including a first portion on a first side of the protection pattern, and a second portion below the first portion; forming a source electrode on the second conductivity type doping well region; and forming a drain electrode on a second surface of the first conductivity type substrate, the first surface and the second surface facing in opposite directions from each other.

According to an aspect of an embodiment of the present disclosure, a semiconductor device includes: a first conductivity type substrate; a first conductivity type semiconductor layer on a first surface of the first conductivity type substrate; a gate electrode on the first conductivity type semiconductor layer; a gate insulation layer between the first conductivity type semiconductor layer and the gate electrode; a first interlayer insulating layer including a first portion on an upper surface of the gate electrode and a side surface of the gate electrode, and a second portion protruding from a first side surface of the first portion in a horizontal direction; a source electrode on opposite sides of the gate electrode; a protection pattern between the first interlayer insulating layer and the source electrode, and directly contacting the first side surface of the first portion and an upper surface of the second portion; a silicide layer between the protection pattern and the source electrode; a second interlayer insulating layer between the first interlayer insulating layer and the source electrode, and on an upper surface of the protection pattern and an upper surface of the first interlayer insulating layer; a second conductivity type doping layer above the first conductivity type semiconductor layer, and extending a first depth from upper surface of the first conductivity type semiconductor layer towards a lower surface of the first conductivity type semiconductor layer, wherein an upper surface of the second conductivity type doping layer is in direct contact with a lower surface of the source electrode; a first conductivity type doping layer surrounding opposite side surfaces of the second conductivity type doping layer, and including an upper surface in contact with a lower surface of the second portion; and a second conductivity type doping well region above the first conductivity type semiconductor layer, contacting a lower surface of the second conductivity type doping layer, surrounding a lower surface and opposite lateral sides of the first conductivity type doping layer, wherein the second conductivity type doping well region extends a second depth, greater than the first depth, from the upper surface of the first conductivity type semiconductor layer towards the lower surface of the first conductivity type semiconductor layer.

A semiconductor device according to an embodiment of the present disclosure may include a protection pattern that directly contacts a partial region of the interlayer insulating layer covering the gate electrode.

According to an embodiment of the present disclosure, a short circuit generated between a source electrode and a gate electrode due to over-etching of an interlayer insulating layer during a process for etching the interlayer insulating layer may be reduced or prevented. Accordingly, reliability of the semiconductor device may be improved.

### BRIEF DESCRIPTION OF DRAWINGS

The above and other aspects, features, and advantages of certain embodiments of the present disclosure will be more apparent from the following description taken in conjunction with the accompanying drawings, in which:
FIG. 1 is a cross-sectional view showing a semiconductor device according to an embodiment;
FIG. 2 is an enlarged cross-sectional view of a region A of FIG. 1, according to an embodiment;
FIG. 3 is an enlarged cross-sectional view of the region A according to an embodiment;
FIG. 4 is an enlarged cross-sectional view of the region A according to an embodiment;
FIG. 5 is an enlarged cross-sectional view of the region A according to an embodiment;
FIG. 6 is a cross-sectional view showing a semiconductor device according to an embodiment;
FIG. 7 is a cross-sectional view showing a semiconductor device according to an embodiment;
FIGS. 8 to 14 are process cross-sectional views shown according to a process sequence of manufacturing a semiconductor device according to an embodiment.

### DETAILED DESCRIPTION

Non-limiting example embodiments of the present disclosure will be described in detail hereinafter with reference to the accompanying drawings, in which example embodiments of the present disclosure are shown. As those skilled in the art would realize, the described embodiments may be modified in various different ways, all without departing from the scope of the present invention, which is defined by the claims.

The drawings and description are to be regarded as illustrative in nature and not restrictive. Like reference numerals designate like elements throughout the specification.

A size and thickness of each constituent element in the drawings may be arbitrarily illustrated for better understanding and ease of description, and the following embodiments are not limited thereto. In the drawings, a thickness of layers, films, panels, regions, etc., may be exaggerated for clarity. In the drawings, a thickness of some layers and regions may be exaggerated for ease of description.

In addition, it will be understood that when an element such as a layer, film, region, or substrate is referred to as being "above" or "on" another element, it can be directly on the other element or intervening elements may also be present. In contrast, when an element is referred to as being "directly on" another element, there are no intervening elements present. Further, when an element is referred to as being "above" or "on" a reference element, it can be located above or below the reference element, and it is not necessarily referred to as being located "above" or "on" in a direction opposite to gravity.

In addition, unless explicitly described to the contrary, the word "comprise" (or "include"), and variations such as "comprises" (or "includes") or "comprising" (or "including"), will be understood to imply the inclusion of stated elements but not the exclusion of any other elements.

Further, throughout the specification, the phrase "in a plan view" or "on a plane" means viewing a target portion from the top, and the phrase "in a cross-sectional view" or "on a cross-section" means viewing a cross-section formed by vertically cutting a target portion from the side.

No particular orientation of the device is to be inferred from words such as 'upper', 'lower' and, correspondingly, 'above' and 'below'. In embodiments, an 'upper' surface of a substrate generally may be a substrate surface that supports - via at least a semiconductor layer - gate and/or source electrodes, and/or a 'lower' substrate surface may be an other surface that supports a drain electrode. A thickness direction of a device may be a direction exactly or substantially perpendicular to such an 'upper' surface. Similarly, the term "height" generally refers to a distance from the substrate and thus does not imply any particular orientation of the device. Again similarly, the term 'vertical' does not imply any orientation and may generally refer to a direction such as a said thickness direction.

One or more embodiments of the present disclosure provide a semiconductor device capable of having stable electric characteristics and/or improved reliability.

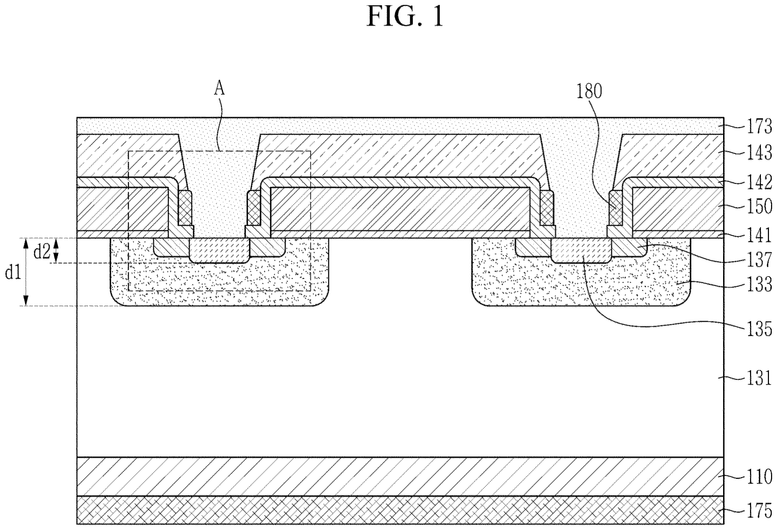

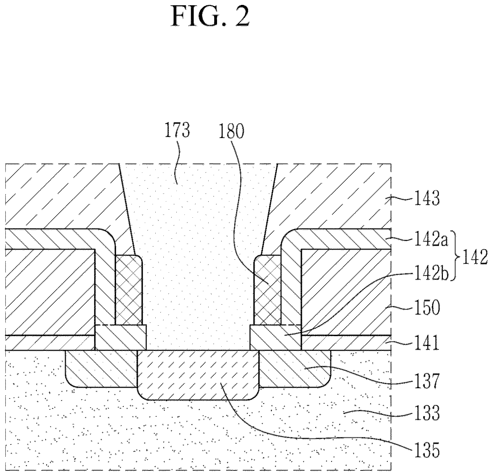

FIG. 1 and FIG. 2 are drawings for explaining a semiconductor device according to an embodiment. Specifically, FIG. 1 is a cross-sectional view showing a semiconductor device according to an embodiment. FIG. 2 is an enlarged cross-sectional view of a region A of FIG. 1.

As shown in FIG. 1, a semiconductor device according to an embodiment may include a substrate 110, a first conductivity type semiconductor layer 131 located on a first surface of the substrate 110, a second conductivity type doping well region 133 located on the first conductivity type semiconductor layer 131, a gate electrode 150 located on the first conductivity type semiconductor layer 131 and the second conductivity type doping well region 133, a gate insulation layer 141 located between the first conductivity type semiconductor layer 131 and the gate electrode 150, a first interlayer insulating layer 142 covering an upper surface and a side surface of the gate electrode 150, a source electrode 173 located on the second conductivity type doping well region 133, a protection pattern 180 located between the first interlayer insulating layer 142 and the source electrode 173, and a drain electrode 175 located on a second surface of the substrate 110.

The substrate 110 may be a semiconductor substrate including SiC. For example, the substrate 110 may be formed as a 4H SiC substrate. According to embodiments, the substrate 110 may be formed as a 3C SiC substrate, a 6H SiC substrate, or the like. The substrate 110 may be doped with a first conductivity type impurity. For example, the first conductivity type impurity may be an n-type impurity. In other words, the substrate 110 may be doped to n-type. The substrate 110 may be doped to n-type at a high concentration. Resistivity of the substrate 110 may be about 0.005 Ωcm or more and about 0.035 Ωcm or less. A thickness of the substrate 110 may be about 200 µm or more and about 700 µm or less. The material, doping type, doping concentration, resistivity, thickness, or the like of the substrate 110 are not limited thereto, and may be changed in various ways. The substrate 110 may include the first surface and the second surface that face in opposite directions. The first surface of the substrate 110 may be an upper surface, and the second surface of the substrate 110 may be a lower surface.

The first conductivity type semiconductor layer 131 may be located on the first surface of the substrate 110, i.e., on an upper surface. A bottom surface of the first conductivity type semiconductor layer 131 may be in contact with an upper surface of the substrate 110. However, embodiments are not limited thereto, and another preset layer may be located between the substrate 110 and the first conductivity type semiconductor layer 131. The first conductivity type semiconductor layer 131 may be an epitaxy layer formed from the substrate 110 by using an epitaxial growth method. The first conductivity type semiconductor layer 131 may include SiC. For example, the first conductivity type semiconductor layer 131 may include 4H SiC. The first conductivity type semiconductor layer 131 may be doped to n-type. The first conductivity type semiconductor layer 131 may be doped to n-type at a low concentration. The doping concentration of the first conductivity type semiconductor layer 131 may be lower than the doping concentration of the substrate 110. The doping concentration of the first conductivity type semiconductor layer 131 may be about 1*10¹⁵cm⁻³ or more and about 5*10¹⁶cm⁻³ or less. A thickness of the first conductivity type semiconductor layer 131 may be about 7 µm or more and about 13 µm or less. The material, doping type, doping concentration, thickness, etc., of the first conductivity type semiconductor layer 131 is not limited thereto, and may be changed in various ways.

The gate electrode 150 may be located on the first conductivity type semiconductor layer 131. The gate electrode 150 may be spaced apart from the first conductivity type semiconductor layer 131. For example, the gate electrode 150 may be spaced apart from the first conductivity type semiconductor layer 131 by the gate insulation layer 141. A semiconductor device according to an embodiment may have a planar gate structure. That is, in a semiconductor device according to an embodiment, the gate electrode 150 may have a flat plate shape in which an upper surface and a lower surface are flat, and a lower surface of the gate electrode 150 may be located at a higher level than a level of an uppermost surface of the first conductivity type semiconductor layer 131. However, embodiments are not limited thereto, and a semiconductor device according to an embodiment may have a gate structure of a trench form. For example, in a semiconductor device according to an embodiment, a trench of a predetermined depth may be formed in the first conductivity type semiconductor layer 131, and the gate electrode 150 may be located within the trench to be spaced apart from the first conductivity type semiconductor layer 131.

The gate electrode 150 may include a conductive material. For example, the gate electrode 150 may include polysilicon doped with impurities. As another example, the gate electrode 150 may include a metal, a metal alloy, a conductive metal nitride, a metal silicide, a doped semiconductor material, a conductive metal oxide and/or a conductive metal nitride oxide, eg a combination of any one or more of those materials. The gate electrode 150 may be formed as a single layer or may include multiple layers.

The gate insulation layer 141 may be located between the first conductivity type semiconductor layer 131 and the gate electrode 150. That is, the gate insulation layer 141 may be located below the gate electrode 150, and may cover a lower surface of the gate electrode 150. The gate electrode 150 may be insulated from the first conductivity type semiconductor layer 131 by the gate insulation layer 141. A thickness of the gate insulation layer 141 may be substantially constant. The gate insulation layer 141 may include an insulating material. For example, the gate insulation layer 141 may include SiO₂. However, embodiments are not limited thereto, and a material of the gate insulation layer 141 may be changed in various ways. As another example, the gate insulation layer 141 may include SiN, SiON, SiC and/or SiCN, eg a combination of any one or more of those materials. The gate insulation layer 141 may be formed as a single layer or may include multiple layers.

The first interlayer insulating layer 142 may be located on the gate electrode 150. Specifically, the first interlayer insulating layer 142 may cover the upper surface and the side surface of the gate electrode 150. The first interlayer insulating layer 142 may cover a side surface of the gate insulation layer 141. The first interlayer insulating layer 142 may also be located on a first conductivity type doping layer 137 described below. The first interlayer insulating layer 142 may have a lower surface in contact with at least a portion of an upper surface of the first conductivity type doping layer 137. The gate electrode 150 may be insulated from the source electrode 173 by the first interlayer insulating layer 142.

Referring to FIG. 2, in a semiconductor device according to an embodiment, the first interlayer insulating layer 142 may include a first portion 142a covering the gate electrode 150 and a second portion 142b connected to the first portion 142a. Referring to FIG. 2, the first portion 142a may cover an upper surface and at least a portion of the side surface of the gate electrode 150. The second portion 142b may cover a remaining portion of the side surface of the gate electrode 150, and the side surface of the gate insulation layer 141. A first end of the second portion 142b may protrude from a first side surface of the first portion 142a, by a predetermined length in a horizontal direction. An upper surface of the second portion 142b may be in contact with a lower surface of the protection pattern 180, and a side surface of the second portion 142b may be in contact with the source electrode 173. At least a partial region of a lower surface of the second portion 142b may be in contact with the upper surface of the first conductivity type doping layer 137. The lower surface of the second portion 142b may or may not contact an upper surface of a second conductivity type doping layer 135 described below.

The first interlayer insulating layer 142 may include an insulating material. In an embodiment, the first interlayer insulating layer 142 may include the same insulating material as an insulating material of the gate insulation layer 141. For example, the first interlayer insulating layer 142 may include SiO₂. However, embodiments are not limited thereto, and the first interlayer insulating layer 142 may include various types of insulating materials for insulating the gate electrode 150 from the source electrode 173. For example, the first interlayer insulating layer 142 may include SiOP, SiN and/or SiON, eg a combination of any one or more of these materials. The first interlayer insulating layer 142 may be formed as a single layer or may include multiple layers. When the first interlayer insulating layer 142 is formed of the same material as the material of the gate insulation layer 141, a boundary between the first interlayer insulating layer 142 and the gate insulation layer 141 may not be clearly distinguished in a portion where the first interlayer insulating layer 142 and the gate insulation layer 141 are in contact with each other.

The source electrode 173 may be located on the second conductivity type doping well region 133. The second conductivity type doping layer 135 may be located between the source electrode 173 and the second conductivity type doping well region 133. The source electrode 173 may be electrically connected to the second conductivity type doping well region 133 by the second conductivity type doping layer 135. The source electrode 173 may be located on opposite sides of the gate electrode 150. However, embodiments are not limited thereto, and the source electrode 173 may be located only on a first side of the gate electrode 150. The first interlayer insulating layer 142 and/or a second interlayer insulating layer 143 may be located between the source electrode 173 and the gate electrode 150. Through the source electrode 173, a current or voltage may be provided to a semiconductor device according to an embodiment. The source electrode 173 may be spaced apart from the gate electrode 150 by the first interlayer insulating layer 142 and/or the second interlayer insulating layer 143. A lower surface of the source electrode 173 may directly contact the upper surface of the second conductivity type doping layer 135. The source electrode 173 may be in contact with a side surface of the first interlayer insulating layer 142, a side surface of the second interlayer insulating layer 143, and a side surface of the protection pattern 180.

The source electrode 173 may include a conductive material. For example, the source electrode 173 may include a metal, a metal alloy, a conductive metal nitride, a metal silicide, a doped semiconductor material, a conductive metal oxide, a conductive metal nitride oxide, or the like. The source electrode 173 may include, for example, at least one from among titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAlN), tantalum aluminum nitride (TaAIN), tungsten nitride (WN), ruthenium (Ru), titanium aluminum (TiAl), titanium aluminum carbonitride (TiAlC-N), titanium aluminum carbide (TiAlC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), Zinc (Zn) and/or vanadium (V), eg a combination of any one or more of those, but is not limited thereto. The source electrode 173 may be formed as a single layer or may include multiple layers.

The protection pattern 180 may be located on a side surface of the first interlayer insulating layer 142. In a manufacturing process of a semiconductor device according to an embodiment, the protection pattern 180 may reduce or prevent (substantially or fully) the first interlayer insulating layer 142 from being over-etched. The protection pattern 180 may be located between the first interlayer insulating layer 142 and the source electrode 173. Specifically, a first side surface of the protection pattern 180 may be in contact with an exterior side of the first portion 142a of the first interlayer insulating layer 142, and a second side surface of the protection pattern 180 may be in contact with the source electrode 173. The lower surface of the protection pattern 180 may be in contact with the upper surface of the second portion 142b of the first interlayer insulating layer 142. An upper surface of the protection pattern 180 may be in contact with the second interlayer insulating layer 143. A portion of the upper surface of the protection pattern 180 may also be in contact with the source electrode 173. In an embodiment, the protection pattern 180 may have an upper surface in contact with both the second interlayer insulating layer 143 and the source electrode 173.

The protection pattern 180 may have an upper surface having a corner having a curved shape for example in a cross-section perpendicular to an upper surface of the substrate. For example, as shown in FIG. 1 and FIG. 2, among two corners located in an upper portion of the protection pattern 180, a corner located more adjacent to the source electrode 173 in the horizontal direction may be curved. However, corners of the protection pattern 180 may have a different shape from the shapes shown in FIG. 1 and FIG. 2. For example, among two corners located in the upper portion of the protection pattern 180, a corner located farther from the source electrode 173 in the horizontal direction may have a curved shape, a corner located more adjacent from the source electrode 173 in the horizontal direction may have a right-angular shape. For example, two corners located in the upper portion of the protection pattern 180 may each have a curved shape, or two corners located in the upper portion of the protection pattern 180 may each have a right-angular shape. Generally, a curved shape lacks a sharp feature such as a point or edge eg having an acute or exactly or substantially 90 degree angle; a curved shape may be rounded.

In an embodiment, the protection pattern 180 may have an upper surface located at a height substantially the same as or lower than a height of an upper surface of the first interlayer insulating layer 142. Specifically, the upper surface of the protection pattern 180 may be located at a height substantially the same as or lower than a height of an upper surface of the first portion 142a of the first interlayer insulating layer 142. In an embodiment, in a region where the protection pattern 180 and the second portion 142b are adjacent to each other, the side surface of the protection pattern 180 and the side surface of the second portion 142b may be aligned on a same plane (e.g., may be coplanar with each other). In an embodiment, an interface between the source electrode 173 and the protection pattern 180 may be aligned on a same plane as an interface between the source electrode 173 and the second portion 142b. In other words, the interface between the source electrode 173 and the protection pattern 180 and the interface between the source electrode 173 and the second portion 142b may completely overlap in a thickness direction (e.g., a vertical direction).

In an embodiment, the protection pattern 180 may include a material having an etch selectivity with respect to the first interlayer insulating layer 142 and the second interlayer insulating layer 143. In an embodiment, the protection pattern 180 may include polysilicon. However, embodiments are not limited thereto, and the protection pattern 180 may include various materials having an etch selectivity with respect to the first interlayer insulating layer 142 and the second interlayer insulating layer 143. (Where a first material has an 'etch selectivity' with respect to a second material, the first material generally has a faster etch rate than the second material when exposed to a particular etchant, for example such that the second material acts as an etch barrier).

For example, the protection pattern 180 may include an insulating material different from the insulating material included in the first interlayer insulating layer 142 and the second interlayer insulating layer 143. At this time, the insulating material included in the protection pattern 180 may be a material having an etch selectivity with respect to the first interlayer insulating layer 142 and the second interlayer insulating layer 143. For example, when the first interlayer insulating layer 142 and the second interlayer insulating layer 143 includes SiO₂, the protection pattern 180 may include SiN_{X}.

The protection pattern 180 may include a conductive material. In such case, the conductive material may be a material having an etch selectivity with respect to the first interlayer insulating layer 142 and the second interlayer insulating layer 143. For example, the protection pattern 180 may include a metal, a metal alloy, a conductive metal nitride, a metal silicide, a doped semiconductor material, a conductive metal oxide, a conductive metal nitride oxide, or the like. The protection pattern 180 may include, for example, at least one from among titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAlN), tantalum aluminum nitride (TaAlN), tungsten nitride (WN), ruthenium (Ru), titanium aluminum (TiAl), titanium aluminum carbonitride (TiAlC-N), titanium aluminum carbide (TiAlC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), Zinc (Zn) and/or vanadium (V), eg a combination of any one or more of those, but is not limited thereto. The protection pattern 180 may be formed as a single layer or may include multiple layers. For example, the source electrode 173 and the protection pattern 180 may, relative to each other, include a different combination or one or more metals.

The drain electrode 175 may be located on the second surface of the substrate 110, i.e., on a lower surface. An upper surface of the drain electrode 175 may be in contact with a lower surface of the substrate 110. The drain electrode 175 may be in ohmic contact with the substrate 110. A region in contact with the drain electrode 175 within the substrate 110 may doped at a relatively high concentration compared to other regions of the substrate 110. However, embodiments are not limited thereto, and another preset layer may be located between the drain electrode 175 and the substrate 110. For example, a silicide layer may be located between the drain electrode 175 and the substrate 110. The silicide layer may include a metal silicide material. By the metal silicide layer, the drain electrode 175 and the substrate 110 may be smoothly electrically connected.

The drain electrode 175 may include a conductive material. For example, the drain electrode 175 may include a metal, a metal alloy, a conductive metal nitride, a metal silicide, a doped semiconductor material, a conductive metal oxide, a conductive metal nitride oxide, and/or the like. The drain electrode 175 may be formed of a same material as a material of the source electrode 173, or may be formed of different materials from each other. The drain electrode 175 may be formed as a single layer or may include multiple layers.

A semiconductor device according to an embodiment may further include the second interlayer insulating layer 143 located on the first interlayer insulating layer 142. The second interlayer insulating layer 143 may cover the upper surface of the first interlayer insulating layer 142 and a portion of the upper surface of the protection pattern 180. The second interlayer insulating layer 143 may be located between the first interlayer insulating layer 142 and the source electrode 173. The second interlayer insulating layer 143 may be formed on the first interlayer insulating layer 142 at a predetermined thickness, and may insulate the gate electrode 150 from the source electrode 173 together with the first interlayer insulating layer 142. In an embodiment, the second interlayer insulating layer 143 may have a thicker thickness than a thickness of the first interlayer insulating layer 142.

A lower surface of the second interlayer insulating layer 143 may directly contact a partial region of the side surface of the first interlayer insulating layer 142 and the upper surface of the first interlayer insulating layer 142. The lower surface of the second interlayer insulating layer 143 may also be in contact with a partial region of the upper surface of the protection pattern 180. The upper surface and a side surface of the second interlayer insulating layer 143 may be surrounded by the source electrode 173. The second interlayer insulating layer 143 may have a side surface inclined with respect to the upper surface of the protection pattern 180. For example, in a portion where the side surface of the second interlayer insulating layer 143 and the upper surface of the protection pattern 180 contact each other, an angle formed between the side surface of the second interlayer insulating layer 143 and the upper surface of the protection pattern 180 may be an acute angle.

The second interlayer insulating layer 143 may include an insulating material. In an embodiment, the second interlayer insulating layer 143 may include a same insulating material as an insulating material of the gate insulation layer 141 and/or the first interlayer insulating layer 142. The second interlayer insulating layer 143 may include silicon oxide. In an embodiment, the second interlayer insulating layer 143 may include SiO₂. In an embodiment, the second interlayer insulating layer 143 may include borophosphosilicate glass (BPSG). However, embodiments are not limited thereto, and the second interlayer insulating layer 143 may include various types of insulating materials for insulating the gate electrode 150 from the source electrode 173. For example, the second interlayer insulating layer 143 may include SiOP, SiN and/or SiON, eg a combination of any one or more of those materials. The second interlayer insulating layer 143 may be formed as a single layer or may include multiple layers. When the second interlayer insulating layer 143 is formed of the same material as a material of the first interlayer insulating layer 142, a boundary between the second interlayer insulating layer 143 and the first interlayer insulating layer 142 may not be clearly distinguished in a portion where the second interlayer insulating layer 143 and the first interlayer insulating layer 142 are in contact with each other.

The second conductivity type doping well region 133 may be located above the first conductivity type semiconductor layer 131. The second conductivity type doping well region 133 may be in contact with a lower surface of the second conductivity type doping layer 135 for example as described below. The second conductivity type doping well region 133 may surround the lower surface and the side surface of the first conductivity type doping layer 137.

In an embodiment, at least a partial region of an upper surface of the second conductivity type doping well region 133 may be overlapped by at least a portion of the gate electrode 150 and at least a portion of the gate insulation layer 141 in the thickness direction. In an embodiment, the upper surface of the second conductivity type doping well region 133 may directly contact a partial region of a lower surface of the gate insulation layer 141. The second conductivity type doping well region 133 may have a width wider than a width of the second conductivity type doping layer 135. In an embodiment, the second conductivity type doping well region 133 may extend by a first depth d1, in a direction from an upper surface of the first conductivity type semiconductor layer 131 to a lower surface of the first conductivity type semiconductor layer 131. The second conductivity type doping well region 133 may be formed in at least a partial region of the first conductivity type semiconductor layer 131 by an ion implantation method.

The second conductivity type doping well region 133 may include SiC. For example, the second conductivity type doping well region 133 may include 4H SiC. The second conductivity type doping well region 133 may be doped to p-type. The second conductivity type doping well region 133 may be doped to p-type in a low concentration. The doping concentration of the second conductivity type doping well region 133 may be about 1*10¹⁷cm⁻³ or more and about 1*10¹⁹cm⁻³ or less. The material, doping type, doping concentration, etc., of the second conductivity type doping well region 133 is not limited thereto, and may be changed in various ways.

A semiconductor device according to an embodiment may further include the second conductivity type doping layer 135 and the first conductivity type doping layer 137 located above the first conductivity type semiconductor layer 131.

The second conductivity type doping layer 135 may be located above the first conductivity type semiconductor layer 131, and may have an upper surface in direct contact with the lower surface of the source electrode 173. In an embodiment, at least a partial region of the upper surface of the second conductivity type doping layer 135 may be in contact with the lower surface of the source electrode 173. In an embodiment, at least the partial region of the upper surface of the second conductivity type doping layer 135 may be in contact with an entire region of the lower surface of the source electrode 173. In a portion where the second conductivity type doping layer 135 and the source electrode 173 contact each other, the second conductivity type doping layer 135 may have a width equal to or wider than a width of the source electrode 173. In an embodiment, the second conductivity type doping layer 135 may extend by a second depth d2, in a direction from the upper surface of the first conductivity type semiconductor layer 131 to the lower surface of the first conductivity type semiconductor layer 131. The second depth d2 may be shallower than the first depth d1. The second conductivity type doping layer 135 may be formed in at least a partial region of the second conductivity type doping well region 133 by an ion implantation method.

The second conductivity type doping layer 135 may include SiC. For example, the second conductivity type doping layer 135 may include 4H SiC. The second conductivity type doping layer 135 may be doped to p-type. The second conductivity type doping layer 135 may be in ohmic contact with the source electrode 173. To this end, the second conductivity type doping layer 135 may be doped to p-type at a high concentration. In an embodiment, the doping concentration of the second conductivity type doping layer 135 may be higher than the doping concentration of the second conductivity type doping well region 133. The doping concentration of the second conductivity type doping layer 135 may be about 1*10¹⁸cm⁻³ or more and about 5*10²⁰cm⁻³ or less. The material, doping type and/or doping concentration, etc., of the second conductivity type doping layer 135 is not limited thereto, and may be changed in various ways.

The first conductivity type doping layer 137 may be located above the first conductivity type semiconductor layer 131, and may surround opposite side surfaces of the second conductivity type doping layer 135. The upper surface of the first conductivity type doping layer 137 may be overlapped by at least a portion of the gate electrode 150 and at least a portion of the gate insulation layer 141 in the thickness direction. The upper surface of the first conductivity type doping layer 137 may directly contact the partial region of the lower surface of the gate insulation layer 141. The upper surface of the first conductivity type doping layer 137 may also directly contact a partial region of a lower surface of the first interlayer insulating layer 142. Specifically, the upper surface of the first conductivity type doping layer 137 may directly contact at least a portion of the lower surface of the second portion 142b.

The first conductivity type doping layer 137 may be a doping region formed within the first conductivity type semiconductor layer 131 by using an ion implantation process. The first conductivity type doping layer 137 may include SiC. For example, the first conductivity type doping layer 137 may include 4H SiC. The first conductivity type doping layer 137 may be doped to n-type. The first conductivity type doping layer 137 may be doped to n-type in a high concentration. The doping concentration of the first conductivity type doping layer 137 may be about 1*10¹⁸cm⁻³ or more and about 5*10²⁰cm⁻³ or less. The material, doping type, doping concentration, etc., of the first conductivity type doping layer 137 is not limited thereto, and may be changed in various ways.

As shown in FIG. 1 and FIG. 2, a semiconductor device according to an embodiment may further include the protection pattern 180 located between the source electrode 173 and the first interlayer insulating layer 142. In a manufacturing process of a semiconductor device according to an embodiment, in order to form the source electrode 173, a partial region of the second interlayer insulating layer 143 overlapping the second conductivity type doping layer 135 in the thickness direction may be etched. At this time, according to a comparative embodiment, when the second interlayer insulating layer 143 is excessively etched, a portion of the first interlayer insulating layer 142 may also be etched, and a short circuit may occur between the gate electrode 150 and the source electrode 173 formed thereafter. As shown in FIG. 1 and FIG. 2, when the protection pattern 180 is located on the side surface of the first interlayer insulating layer 142, etching a portion of the first interlayer insulating layer 142 during the process of etching the second interlayer insulating layer 143 may be reduced or prevented and, accordingly, reliability of the semiconductor device may be improved.

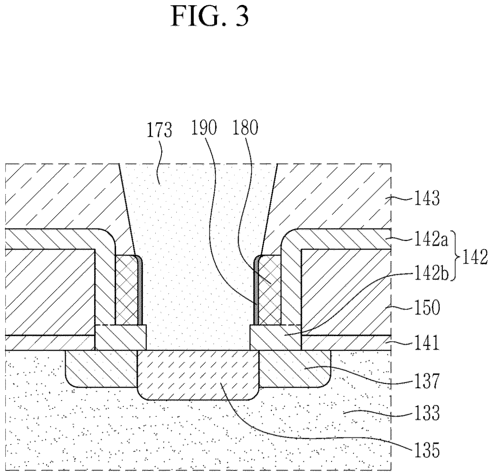

FIG. 3 is an enlarged cross-sectional view of the region A according to an embodiment.

The semiconductor device shown in FIG. 3 may have many of the same portions as a semiconductor device according to an embodiment described above and, accordingly, redundant descriptions thereof may not be repeated, and the following description may mainly focus on the differences. A semiconductor device according to an embodiment may be partially different from the previous embodiment in that a silicide layer 190 is included.

Referring to FIG. 3, in a semiconductor device according to an embodiment, the silicide layer 190 may be located between the protection pattern 180 and the source electrode 173. The silicide layer 190 may be located along a side surface profile of the protection pattern 180. The silicide layer 190 may be in contact with the first side surface of the protection pattern 180. The silicide layer 190 may also contact a portion of the source electrode 173. Specifically, a first side surface of the silicide layer 190 may be in contact with the protection pattern 180, and a second side surface of the silicide layer 190 may be in contact with the source electrode 173. The silicide layer 190 may be located along the interface between the source electrode 173 and the protection pattern 180. In an embodiment, the silicide layer 190 may have a narrower width compared to a width along a horizontal direction of the protection pattern 180 and a width along a horizontal direction of the source electrode 173.

The silicide layer 190 may include metal silicide material. For example, the silicide layer 190 may include tungsten silicide (WSi), titanium silicide (TiSi), cobalt silicide (CoSi) and/or nickel silicide (NiSi), eg a combination of any one or more of those materials.

In a manufacturing process of a semiconductor device according to an embodiment, after forming the source electrode 173, in order to reduce contact resistance between the second conductivity type doping layer 135 and the source electrode 173, an annealing process may be performed subsequently. The annealing process may be performed at, for example, 300°C to 800°C. When the protection pattern 180 includes polysilicon, in the annealing process, the metallic material included in the source electrode 173 may penetrate into the protection pattern 180, and accordingly, the silicide layer 190 may be formed along the interface between the source electrode 173 and the protection pattern 180.

A semiconductor device according to an embodiment may further include a silicide layer formed in an interface between the second conductivity type doping layer 135 and the source electrode 173. In this case, the silicide layer may be located along the interface between the second conductivity type doping layer 135 and the source electrode 173. In an embodiment, the silicide layer may have a narrower width compared to a width along a vertical direction of the second conductivity type doping layer 135 and a width along the vertical direction of the source electrode 173.

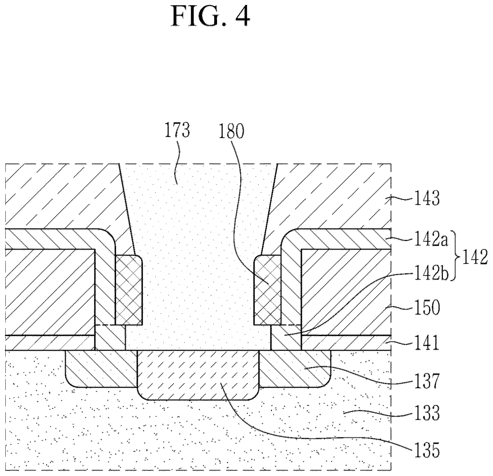

FIG. 4 is an enlarged cross-sectional view of the region A according to an embodiment.

The semiconductor device shown in FIG. 4 may have many of the same portions as a semiconductor device according to an embodiment described above and, accordingly, redundant descriptions thereof may not be repeated, and the following description may mainly focus on the differences. A semiconductor device according to an embodiment may be partially different from the previous embodiments with respect to shapes and/or locations of the first interlayer insulating layer 142 and/or the source electrode 173.

Referring to FIG. 4, the source electrode 173 may also be located below the protection pattern 180. The protection pattern 180 may have a lower surface of which a partial region is in contact with the source electrode 173. The source electrode 173 may have a lower surface of which a partial region is in contact with the upper surface of the first conductivity type doping layer 137.

As shown in FIG. 4, an interface between the second portion 142b and the source electrode 173 may be located between opposite lateral sides of the protection pattern 180. That is, among opposite side surfaces of the protection pattern 180, when a surface in contact with the first portion 142a is referred to as a first side surface and a surface in contact with the source electrode 173 is referred to as a second side surface, the interface between the second portion 142b and the source electrode 173 may be located between the first side surface and the second side surface. In another embodiment, the interface between the second portion 142b and the source electrode 173 may be closer than the first side surface of the protection pattern 180 to the gate electrode 150.

In a manufacturing process of a semiconductor device according to an embodiment, in order to form the source electrode 173, a partial region of the second interlayer insulating layer 143 overlapping the second conductivity type doping layer 135 in the thickness direction may be etched. In an embodiment, the protection pattern 180 may include a material having an etch selectivity with respect to the first interlayer insulating layer 142 and the second interlayer insulating layer 143. Accordingly, in the process of etching the second interlayer insulating layer 143, when the second interlayer insulating layer 143 is etched, as shown in FIG. 4, the source electrode 173 may also be formed below the protection pattern 180.

A semiconductor device according to an embodiment may further include a silicide layer formed in the interface between the source electrode 173 and the protection pattern 180. Specifically, the silicide layer may be located along the side surface profile of the protection pattern 180. The silicide layer may also be located on a portion of the lower surface of the protection pattern 180. Referring to FIG. 4, the portion of the lower surface of the protection pattern 180 may overlap a partial region of the source electrode 173 located below the protection pattern 180, in the vertical direction. In this case, the silicide layer may be located on the portion of the lower surface of the protection pattern 180 overlapping a portion of the source electrode 173 located below the protection pattern 180 in the vertical direction.

A semiconductor device according to an embodiment may further include a silicide layer formed in the interface between the second conductivity type doping layer 135 and the source electrode 173, and/or in an interface between the first conductivity type doping layer 137 and the source electrode 173. In this case, the silicide layer may be located along the interface between the second conductivity type doping layer 135 and the source electrode 173, and/or the interface between the first conductivity type doping layer 137 and the source electrode 173.

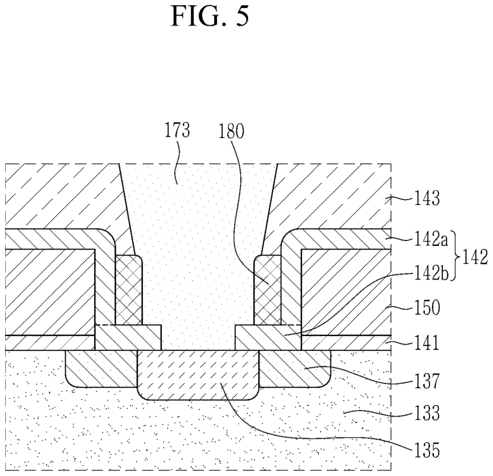

FIG. 5 is an enlarged cross-sectional view of the region A according to an embodiment.

The semiconductor device shown in FIG. 5 may have many of the same portions as a semiconductor device according to an embodiment described above and, accordingly, redundant descriptions thereof may not be repeated, and the following description may mainly focus on the differences. A semiconductor device according to an embodiment may be partially different from the previous embodiments with respect to shapes and/or locations of the first interlayer insulating layer 142 and/or the source electrode 173.

Referring to FIG. 5, the first end of the second portion 142b may protrude in the horizontal direction from an interface between the protection pattern 180 and the source electrode 173. Specifically, a first side surface, in contact with the source electrode 173, of the second portion 142b may be located farther in the horizontal direction, than the interface between the source electrode 173 and the protection pattern 180, from a first side surface of the gate electrode 150.

In an embodiment, the second portion 142b may have an upper surface of which a portion is in contact with the source electrode 173. In an embodiment, the second portion 142b may have a lower surface of which a portion is in contact with the upper surface of the second conductivity type doping layer 135.

In a manufacturing process of a semiconductor device according to an embodiment, in order to form the source electrode 173, a partial region of the second interlayer insulating layer 143 overlapping the second conductivity type doping layer 135 in the thickness direction may be etched. At this time, according to a comparative embodiment, there may be a case that the second interlayer insulating layer 143 is not sufficiently etched to expose an entire region of the upper surface of the second conductivity type doping layer 135 in contact with the source electrode 173. In this case, as shown in FIG. 5, the second portion 142b may have a shape in which a first end thereof protrudes from the interface between the protection pattern 180 and the source electrode 173 in the horizontal direction.

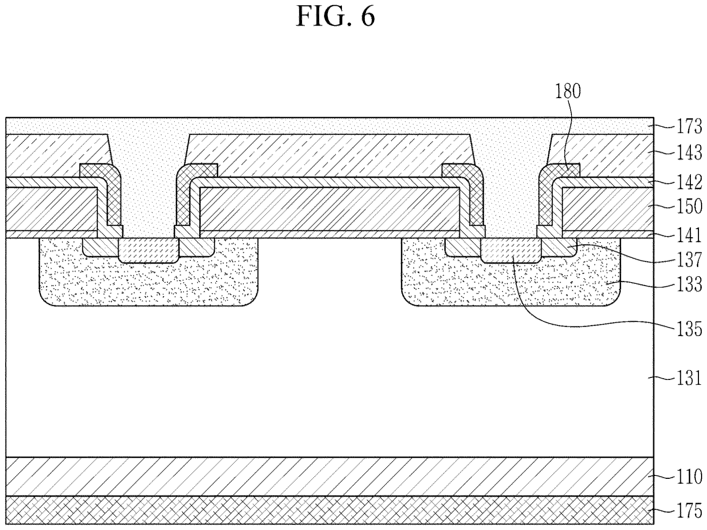

FIG. 6 is a cross-sectional view showing a semiconductor device according to an embodiment.

The semiconductor device shown in FIG. 6 may have many of the same portions as a semiconductor device according to an embodiment described above and, accordingly, redundant descriptions thereof may not be repeated, and the following description may mainly focus on the differences. A semiconductor device according to an embodiment may be partially different from the previous embodiments with respect to the location where the protection pattern 180 is formed.

Referring to FIG. 6, the protection pattern 180 according to an embodiment may also be located between the upper surface of the first interlayer insulating layer 142 and the second interlayer insulating layer 143. Specifically, the protection pattern 180 may cover the side surface of the first portion 142a of the first interlayer insulating layer 142 and, a partial region of the upper surface of the first portion 142a. The protection pattern 180 may further include a portion contacting a portion of the upper surface of the first portion 142a. In an embodiment, the protection pattern 180 may have a generally L-shape, or an inverted /or rotated form of the L-shape.

In a semiconductor device according to an embodiment, the protection pattern 180 may also be located on a partial region of the upper surface of the first interlayer insulating layer 142, as well as on the side surface of the first interlayer insulating layer 142. Accordingly, in the process of etching the second interlayer insulating layer 143, when the second interlayer insulating layer 143 is excessively etched, the side surface and the upper surface of the first interlayer insulating layer 142 may be protected more effectively compared to the previous embodiments.

In a manufacturing process of a semiconductor device according to an embodiment, the region where the second interlayer insulating layer 143 is etched may be define by a hard mask. At this time, due to mask misalignment, a partial region of the second interlayer insulating layer 143 overlapping the gate electrode 150 in the thickness direction may be etched. According to an embodiment, even in this case, by the protection pattern 180 being located on the upper surface of the first interlayer insulating layer 142, the first interlayer insulating layer 142 may be protected from the etchant.

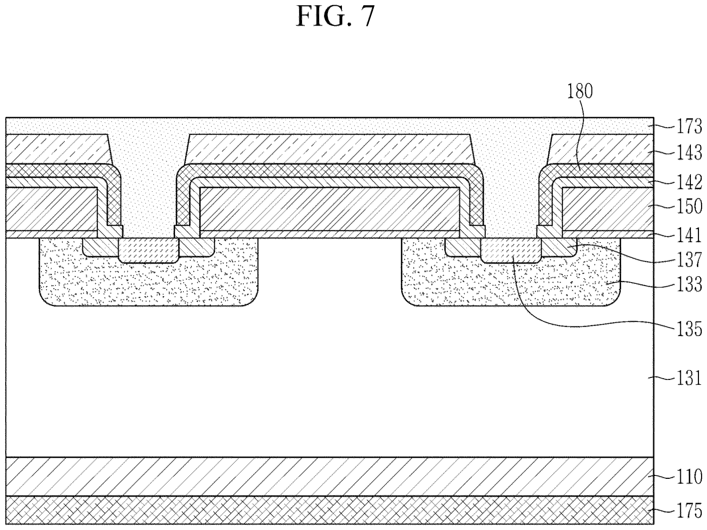

FIG. 7 is a cross-sectional view showing a semiconductor device according to an embodiment.

The semiconductor device shown in FIG. 7 may have many of the same portions as a semiconductor device according to an embodiment described above and, accordingly, redundant descriptions thereof may not be repeated, and the following description may mainly focus on the differences. A semiconductor device according to an embodiment may be partially different from the previous embodiments with respect to the location where the protection pattern 180 is formed.

Referring to FIG. 7, the protection pattern 180 according to an embodiment may be located between the upper surface of the first interlayer insulating layer 142 and the second interlayer insulating layer 143. Specifically, the protection pattern 180 may cover the side surface of the first portion 142a of the first interlayer insulating layer 142, and an entire region of the upper surface of the first portion 142a. The protection pattern 180 may contact an entire side surface of the first portion 142a and an entire upper surface of the first portion 142a. Accordingly, in the process of etching the second interlayer insulating layer 143, when the second interlayer insulating layer 143 is excessively etched, the first interlayer insulating layer 142 may be protected more effectively compared to the previous embodiments.

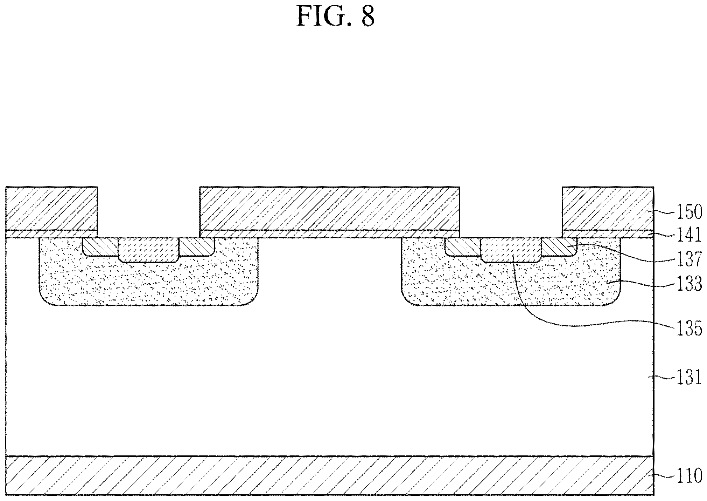

Subsequently, with reference to FIG. 8 to FIG. 14, a manufacturing method of a semiconductor device according to an embodiment will be described. FIG. 8 to FIG. 14 are process cross-sectional views shown according to a process sequence of manufacturing a semiconductor device according to an embodiment.

As shown in FIG. 8, on the first conductivity type semiconductor layer 131 located on the substrate 110, the second conductivity type doping well region 133, the first conductivity type doping layer 137, and the second conductivity type doping layer 135 may be sequentially formed, and then the gate insulation layer 141 and the gate electrode 150 on the first conductivity type semiconductor layer 131 may be formed.

The substrate 110 may be a semiconductor substrate including SiC. For example, the substrate 110 may be formed as a 4H SiC substrate. The substrate 110 may be doped to n-type at a high concentration. The substrate 110 may include the first surface and the second surface facing in opposite directions from each other. The first surface of the substrate 110 may be an upper surface, and the second surface of the substrate 110 may be a lower surface.

The first conductivity type semiconductor layer 131 may be formed on the first surface (e.g., the upper surface) of the substrate 110 by using an epitaxial growth method. The first conductivity type semiconductor layer 131 may be formed directly on the substrate 110, and alternatively, after forming another preset layer on the substrate 110, the first conductivity type semiconductor layer 131 may be form thereon. The first conductivity type semiconductor layer 131 may include SiC. For example, the first conductivity type semiconductor layer 131 may include 4H SiC. The first conductivity type semiconductor layer 131 may be doped to n-type at a low concentration. The doping type of the first conductivity type semiconductor layer 131 may be the same as the doping type of the substrate 110. The doping material of the first conductivity type semiconductor layer 131 may be the same as the doping material of the substrate 110, or may be different therefrom. The doping concentration of the first conductivity type semiconductor layer 131 may be lower than the doping concentration of the substrate 110.

Subsequently, the second conductivity type doping well region 133 may be formed in an upper portion of the first conductivity type semiconductor layer 131. The second conductivity type doping well region 133 may be formed by an ion implantation process (IIP). First, by using the photolithography process, the region where the second conductivity type doping well region 133 is formed may be defined on the first conductivity type semiconductor layer 131. Thereafter, a second conductivity type impurity ion may be implanted into a corresponding region. The second conductivity type doping well region 133 may have a predetermined depth. In such case, a depth of the second conductivity type doping well region 133 may be determined by the number of implanted ions and/or the speed by which ions are accelerated.

In an embodiment, the second conductivity type doping well region 133 may include SiC. For example, the second conductivity type doping well region 133 may include 4H SiC. The second conductivity type doping well region 133 may be doped to p-type. The second conductivity type doping well region 133 may be doped to p-type in a low concentration. For example, doping concentration of the second conductivity type doping well region 133 may be about 1*10¹⁷cm⁻³ or more and about 1*10¹⁹cm⁻³ or less. The material, doping type, doping concentration, etc., of the second conductivity type doping well region 133 is not limited thereto, and may be changed in various ways.

Subsequently, the first conductivity type doping layer 137 may be formed by implanting ions into the second conductivity type doping well region 133. The first conductivity type doping layer 137 may be formed within the second conductivity type doping well region 133 by the ion implantation process. The first conductivity type doping layer 137 may be formed in at least a partial region of the second conductivity type doping well region 133. For example, the first conductivity type doping layer 137 may be formed to a predetermined depth from the upper surface of the second conductivity type doping well region 133.

The first conductivity type doping layer 137 may include SiC. For example, the first conductivity type doping layer 137 may include 4H SiC. The first conductivity type doping layer 137 may be doped to n-type in a high concentration. The doping type of the first conductivity type doping layer 137 may be different from the doping type of the second conductivity type doping well region 133. The doping type of the first conductivity type doping layer 137 may be the same as the doping type of the substrate 110 and the first conductivity type semiconductor layer 131. The doping concentration of the first conductivity type doping layer 137 may be about 1*10¹⁸cm⁻³ or more and about 5*10²⁰cm⁻³ or less. The material, doping type, doping concentration, etc., of the first conductivity type doping layer 137 is not limited thereto, and may be changed in various ways.

Subsequently, by implanting ions into the second conductivity type doping well region 133 and the first conductivity type doping layer 137, the second conductivity type doping layer 135 may be further formed. First, by using the photolithography process, the region where the second conductivity type doping layer 135 is formed may be defined on the first conductivity type doping layer 137. The region where the second conductivity type doping layer 135 is formed may have a width smaller than a width of the second conductivity type doping well region 133 or the first conductivity type doping layer 137. In an embodiment, a depth at which the second conductivity type doping layer 135 is formed may be deeper than a depth of the first conductivity type doping layer 137. The second conductivity type doping layer 135 may penetrate the first conductivity type doping layer 137 in the thickness direction. At least a partial region of opposite side surfaces of the second conductivity type doping layer 135 may be surrounded by the first conductivity type doping layer 137.

The second conductivity type doping layer 135 may include SiC. For example, the second conductivity type doping layer 135 may include 4H SiC. The second conductivity type doping layer 135 may be doped to p-type in a high concentration. The doping type of the second conductivity type doping layer 135 may be the same as the doping type of the second conductivity type doping well region 133. The doping material of the second conductivity type doping layer 135 may be the same as the doping material of the second conductivity type doping well region 133, or may be different therefrom. The doping concentration of the second conductivity type doping layer 135 may be higher than the doping concentration of the second conductivity type doping well region 133.

Subsequently, the gate insulation layer 141 and the gate electrode 150 may be sequentially formed on the first conductivity type semiconductor layer 131. The gate insulation layer 141 and the gate electrode 150 may also be located on the second conductivity type doping well region 133 and the first conductivity type doping layer 137. First, a gate insulating material layer may be formed on the entire region of upper surfaces of the first conductivity type semiconductor layer 131, the second conductivity type doping well region 133, the first conductivity type doping layer 137, and the second conductivity type doping layer 135. The gate insulating material layer may be formed by a high temperature oxidation process. A gate material layer may be formed by depositing polysilicon on the gate insulating material layer. Thereafter, by etching a portion of the gate material layer and the gate insulating material layer, the gate insulation layer 141 and the gate electrode 150 may be formed. At this time, the upper surface of the second conductivity type doping layer 135 and a portion of the upper surface of the first conductivity type doping layer 137 may be exposed.

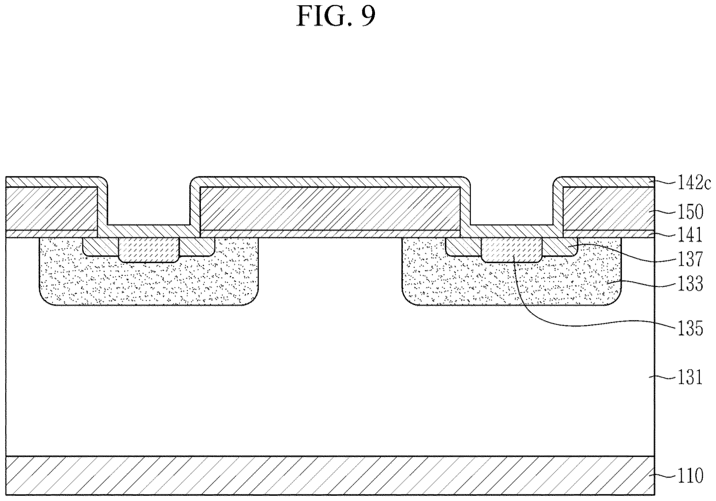

As shown in FIG. 9, a first interlayer insulating material layer 142c covering the gate electrode 150 and the gate insulation layer 140 may be formed. The first interlayer insulating material layer 142c may also cover the upper surface of the second conductivity type doping layer 135 and a partial region of the upper surface of the first conductivity type doping layer 137. The first interlayer insulating material layer 142c may include SiO₂. However, embodiments are not limited thereto, and material of the first interlayer insulating material layer 142c may be changed in various ways. As another example, the first interlayer insulating material layer 142c may include SiN, SiON, SiC and/or SiCN, eg a combination of any one or more of those materials. However, the formation method and material, etc., of the first interlayer insulating material layer 142c is not limited thereto, and may be changed in various ways.

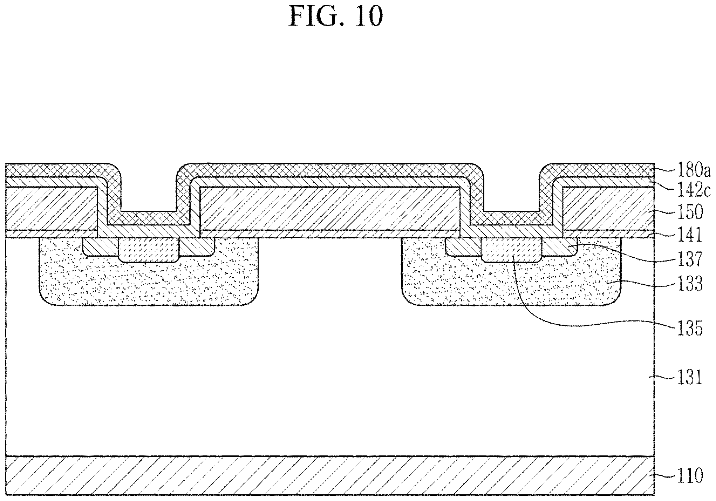

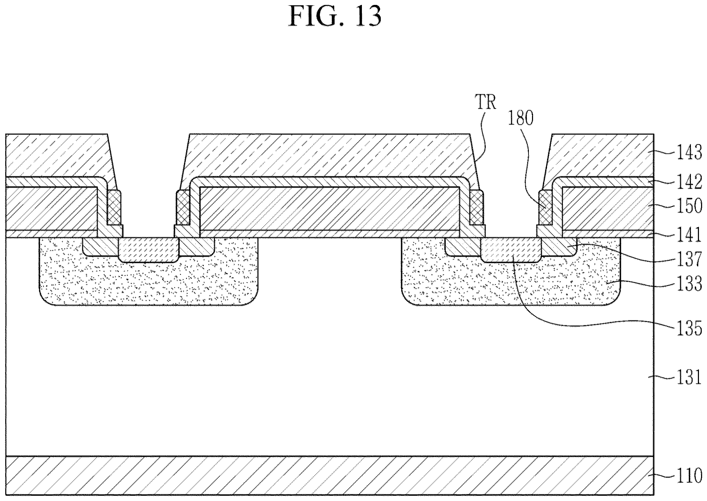

As shown in FIG. 10, a preliminary protection pattern 180a on the first interlayer insulating material layer 142c may be formed. The preliminary protection pattern 180a may include a material having an etch selectivity with respect to the first interlayer insulating layer 142 (see FIG. 13) and the second interlayer insulating layer 143 (see FIG. 13) described below. In an embodiment, the preliminary protection pattern 180a may include polysilicon. However, embodiments are not limited thereto, and the protection pattern 180 may include various materials having an etch selectivity with respect to the first interlayer insulating layer 142 (see FIG. 13) and the second interlayer insulating layer 143 (see FIG. 13), for example, an insulating material or an conductive material. In an embodiment, the preliminary protection pattern 180a may be formed by a chemical vapor deposition (CVD) method. However, embodiments are not limited thereto, and the preliminary protection pattern 180a may be formed by various deposition methods.

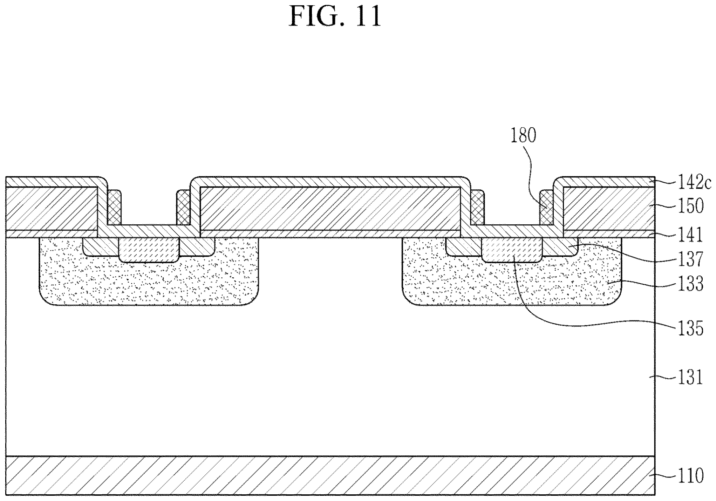

As shown in FIG. 11, the protection pattern 180 may be formed by etching a partial region of the preliminary protection pattern 180a. In an embodiment, the process of forming the protection pattern 180 may be performed by using a self-align process. That is, the process of forming the protection pattern 180 may be performed without a photolithography process using a separate mask pattern. In an embodiment, the preliminary protection pattern 180a may be anisotropically etched. In this case, the etch rate in the vertical direction with respect to the preliminary protection pattern 180a may be greater compared to an etch rate in the horizontal direction. Referring to FIG. 10, in the preliminary protection pattern 180a, a region covering the side surface of the first interlayer insulating material layer 142c may be thicker than the region covering the upper surface of the first interlayer insulating material layer 142c, in the thickness direction (e.g., direction perpendicular to the upper surface of the substrate 110). When the preliminary protection pattern 180a is anisotropically etched, as shown in FIG. 11, even if the region, covering the upper surface of the first interlayer insulating material layer 142c, of the preliminary protection pattern 180a is completely etched, the region covering the side surface is not completely etched and remains such that the protection pattern 180 may be formed.

In an embodiment, the partial region of the preliminary protection pattern 180a may be etched by a dry etching process. For example, the preliminary protection pattern 180a may be removed by the dry etching process such as reactive ion etching (RIE) or inductively coupled plasma (ICP), or the like.

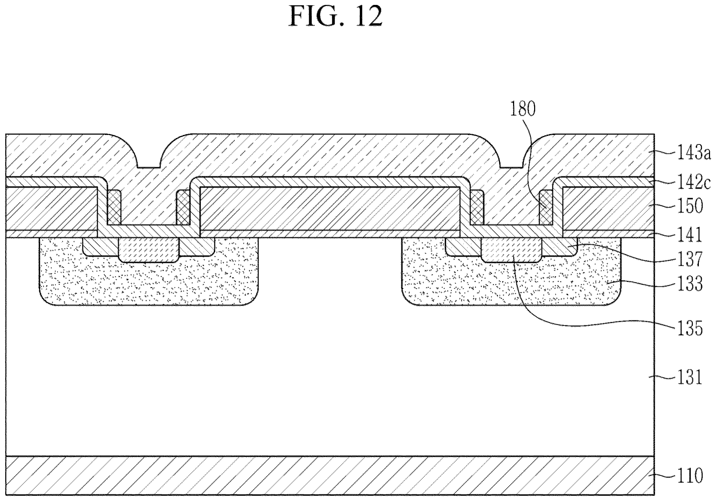

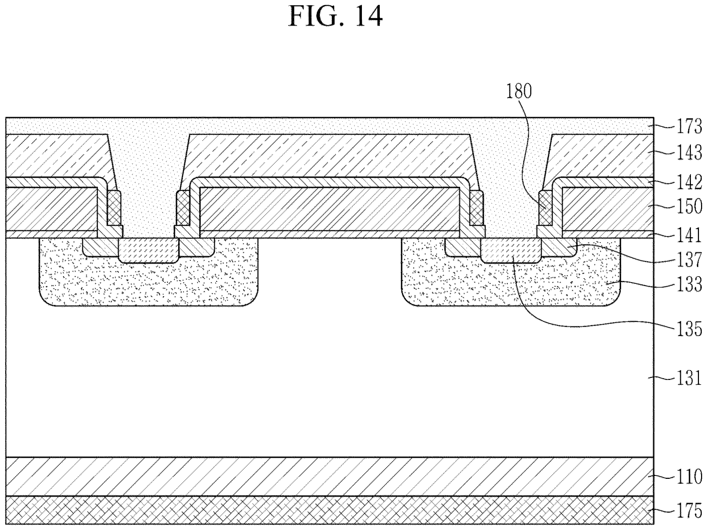

As shown in FIG. 12, on the substrate 110, a second interlayer insulating material layer 143a covering the first interlayer insulating material layer 142c and the protection pattern 180 may be formed. In order to insulate the gate electrode 150 from the source electrode 173 (see FIG. 14) formed in a subsequent process, the second interlayer insulating material layer 143a may be formed in a sufficiently thick thickness.

The second interlayer insulating material layer 143a may include an insulating material. The second interlayer insulating material layer 143a may include the same material as a material of the first interlayer insulating layer 142. In an embodiment, the second interlayer insulating material layer 143a may include SiO₂. In an embodiment, the second interlayer insulating material layer 143a may include borophosphosilicate glass (BPSG). However, embodiments are not limited thereto, and the second interlayer insulating material layer 143a may include various types of insulating materials for insulating the gate electrode 150 from the source electrode 173. For example, the second interlayer insulating material layer 143a may include SiOP, SiNand/or SiON, eg a combination of any one or more of those materials. The second interlayer insulating material layer 143a may be formed as a single layer or may include multiple layers.

As shown in FIG. 13, by etching a partial region of the second interlayer insulating material layer 143a, the second interlayer insulating layer 143 and a trench TR exposing the upper surface of the second conductivity type doping layer 135 may be formed. The trench TR may be formed by a photolithography process. Specifically, the trench TR may be formed by etching a region of the second interlayer insulating material layer 143a overlapping the second conductivity type doping layer 135 in the thickness direction. The second interlayer insulating material layer 143a may be divided by the trench TR, and thereby the second interlayer insulating layer 143 covering the first interlayer insulating layer 142 and the protection pattern 180 may be formed.

In an embodiment, the process of forming the second interlayer insulating layer 143 by etching the second interlayer insulating material layer 143a may be performed by a dry etching process. In such case, the dry etching process may be performed by using an etching solution having a higher etch rate with respect to the second interlayer insulating layer 143, compared to an etch rate of the protection pattern 180.

In an embodiment, the protection pattern 180 may include a material having an etch selectivity with respect to the first interlayer insulating layer 142 and the second interlayer insulating layer 143. For example, the first interlayer insulating layer 142 and the second interlayer insulating layer 143 may include SiO₂, and the protection pattern 180 may include polysilicon. In this case, as shown in FIG. 12 and FIG. 13, when a partial region of the second interlayer insulating material layer 143a is etched, even if the second interlayer insulating material layer 143a is over-etched, the first interlayer insulating layer 142 may be protected by the protection pattern 180, without being etched.

As shown in FIG. 14, the source electrode 173 on the second conductivity type doping layer 135 may be formed, and the drain electrode 175 on the second surface of the substrate 110 may be formed.

The source electrode 173 may fill an interior of the trench TR described above with reference to FIG. 13. Referring to FIG. 14, the source electrode 173 may cover the second conductivity type doping layer 135, the side surface of the first interlayer insulating layer 142, a portion of the upper surface of the second interlayer insulating layer 143, and the protection pattern 180. The gate electrode 150 may be electrically insulated from the source electrode 173 by the first interlayer insulating layer 142 and/or the second interlayer insulating layer 143. The source electrode 173 may directly contact the upper surface of the second conductivity type doping layer 135. In an embodiment, in order to reduce contact resistance between the source electrode 173 and the second conductivity type doping layer 135, an annealing process may be additionally performed. In this case, a silicide layer may be further formed in the interface between the protection pattern 180 and the source electrode 173.

The drain electrode 175 may entirely cover the second surface of the substrate 110. However, embodiments are not limited thereto, and the drain electrode 175 may cover only a partial region of the second surface of the substrate 110. The drain electrode 175 may include a conductive material. For example, the drain electrode 175 may include a metal, a metal alloy, a conductive metal nitride, a metal silicide, a doped semiconductor material, a conductive metal oxide, a conductive metal nitride oxide, or the like. The drain electrode 175 may be formed of the same material as a material of the source electrode 173, or may be formed of different materials from each other. The drain electrode 175 may be formed as a single layer or may include multiple layers.

While non-limiting example embodiments of the present disclosure have been described with reference to the drawings, it is to be understood that embodiments of the present disclosure are not limited to the example embodiments. , Various modifications and equivalent arrangements are included within the scope of the present invention, which is defined by the claims.

## Claims

1. A semiconductor device comprising:
a first conductivity type substrate;
a first conductivity type semiconductor layer on a first surface of the first conductivity type substrate;
a gate electrode on the first conductivity type semiconductor layer;
a second conductivity type doping well region on the first conductivity type semiconductor layer;
a gate insulation layer between the first conductivity type semiconductor layer and the gate electrode;
a first interlayer insulating layer comprising:
a first portion on an upper surface of the gate electrode and a side surface of the gate electrode; and
a second portion protruding from a first side surface of the first portion in a horizontal direction;
a source electrode on the second conductivity type doping well region;
a protection pattern on the second portion of the first interlayer insulating layer, and between the first portion of the first interlayer insulating layer and the source electrode; and
a drain electrode on a second surface of the first conductivity type substrate, the first surface and the second surface facing in opposite directions from each other.

2. The semiconductor device of claim 1, further comprising a second interlayer insulating layer between the first interlayer insulating layer and the source electrode,
wherein the second interlayer insulating layer is on an upper surface of the protection pattern and an upper surface of the first interlayer insulating layer.

3. The semiconductor device of claim 2, wherein the upper surface of the protection pattern contacts the second interlayer insulating layer, and a side surface of the protection pattern is in contact with the source electrode.

4. The semiconductor device of claim 2, wherein the upper surface of the protection pattern contacts the second interlayer insulating layer and the source electrode.

5. The semiconductor device of claim 1, wherein a corner of an upper surface of the protection pattern comprises a curved shape.

6. The semiconductor device of claim 1, wherein an upper surface of the protection pattern is at a height lower than a height of an upper surface of the first portion.

7. The semiconductor device of claim 1, further comprising a silicide layer between the protection pattern and the source electrode.

8. The semiconductor device of claim 2, wherein the protection pattern comprises a material having an etch selectivity with respect to the first interlayer insulating layer and the second interlayer insulating layer.

9. The semiconductor device of claim 2, wherein the first interlayer insulating layer and the second interlayer insulating layer comprises SiO₂, and the protection pattern comprises polysilicon.

10. The semiconductor device of claim 2, wherein the protection pattern comprises a portion between the first interlayer insulating layer and the second interlayer insulating layer, and the portion of the protection pattern contacts an upper surface of the first portion.

11. The semiconductor device of claim 2, wherein a portion of the protection pattern is between the first interlayer insulating layer and the second interlayer insulating layer, and the portion of the protection pattern overlaps at least a portion of the gate electrode in a thickness direction.

12. The semiconductor device of claim 1, wherein
a first side surface of the protection pattern in contact with the first side surface of the first portion, and a second side surface of the protection pattern in contact with the source electrode; and
wherein an interface between the second portion and the source electrode is between the first side surface of the protection pattern and the second side surface of the protection pattern.

13. The semiconductor device of claim 12, wherein a lower surface of the protection pattern is in contact with the source electrode.

14. The semiconductor device of claim 12, further comprising:
a second conductivity type doping layer above the first conductivity type semiconductor layer, and extending by a predetermined depth from an upper surface of the first conductivity type semiconductor layer toward a lower surface of the first conductivity type semiconductor layer; and
a first conductivity type doping layer surrounding opposite side surfaces of the second conductivity type doping layer,
wherein a lower surface of the source electrode contacts an upper surface of the first conductivity type doping layer and an upper surface of the second conductivity type doping layer.

15. The semiconductor device of claim 1, wherein a first side surface of the second portion, that is in contact with the source electrode, is farther in the horizontal direction than an interface between the protection pattern and the source electrode from a first side surface of the gate electrode.
